# FASCICULE DE BREVET EUROPEEN

(11) **EP 3 985 727 B1**
(45) Date de publication et mention de la délivrance du brevet: **19.03.2025**
(21) Numéro de dépôt: 21201130.8
(22) Date de dépôt: 06.10.2021
(51) Int. Cl.: H01L 27/12, H01L 29/66, H01L 29/786

(54) **TRANSISTOR MOS ISOLÉ DU SUBSTRAT D'UN CIRCUIT INTÉGRÉ ET APPLICATION À UNE DÉTECTION D'UNE OUVERTURE D'UN RÉCIPIENT FERMÉ**
MOS-TRANSISTOR, DER VOM SUBSTRAT EINES INTEGRIERTEN SCHALTKREISES ISOLIERT IST, UND ANWENDUNG ZUR ERKENNUNG DER ÖFFNUNG EINES GESCHLOSSENEN BEHÄLTERS
INSULATED MOS TRANSISTOR FOR THE SUBSTRATE OF AN INTEGRATED CIRCUIT AND APPLICATION TO DETECTION OF OPENING OF A CLOSED CONTAINER

(30) Priorité: 19.10.2020 FR 2010681
(43) Date de publication de la demande: 20.04.2022
(73) Titulaire: STMicroelectronics (Rousset) SAS, 13790 Rousset (FR)
(72) Inventeur: FORNARA, Pascal, 83910 Pourrières (FR)
(74) Mandataire: Casalonga

(56) Documents cités:
- WO-A1-2020/099747
- FR-A1- 3 091 786
- US-A- 5 111 260
- US-A- 5 712 496

## Description

Des modes de réalisation et de mise en œuvre de l'invention concernent la microélectronique, notamment les transistors MOS isolés du substrat d'un circuit intégré, mais aussi la détection d'une ouverture d'un récipient fermé contenant par exemple un produit de valeur, par exemple un flacon de parfum, ou encore une bouteille de vin.

Certaines applications requièrent des circuits intégrés comportant des transistors MOS électriquement isolés du substrat du circuit intégré.

Il existe par conséquent un besoin de proposer de tels transistors MOS ayant une structure simple à réaliser, et en particulier compatibles avec les procédés classiques de fabrication CMOS utilisant en particulier deux niveaux de polysilicium mais également compatibles avec les procédés de fabrication de cellules-mémoire non volatiles ayant des transistors de sélection à grille enterrée dans le substrat.

Les documents US 5712496A et FR 3091786 fournissent des exemples de transistors en polysilicium à double grille.

Le document WO 2020/099747 décrit un procédé et dispositif de détection d'une ouverture ou d'une tentative d'ouverture d'un récipient fermé.

L'invention concerne un système tel que défini par la revendication 1 et un procédé de détection tel que défini par la revendication 15.

Des modes de réalisation préférés sont définis par les revendications dépendantes.

Selon un aspect il est proposé un système comprenant un circuit intégré comportant
- un premier substrat et
- au moins un premier transistor MOS.

Ce premier transistor MOS possède
- une première région de polysilicium électriquement isolée du premier substrat et incluant une région de grille,
- une deuxième région de polysilicium électriquement isolée de la première région de polysilicium et du premier substrat, et incluant une région de source, une région de substrat et une région de drain dudit premier transistor,
- la première région de polysilicium étant située entre une zone du premier substrat et la deuxième région de polysilicium.

Ainsi, un tel transistor comporte deux régions de polysilicium, ce qui le rend compatible avec les procédés classiques de fabrication CMOS utilisant deux niveaux de polysilicium.

La région de grille du transistor est incorporée dans la première région de polysilicium (le premier niveau de polysilicium) qui se situe entre le substrat du circuit intégré (appelé « premier substrat ») et la deuxième région de polysilicium (le deuxième niveau de polysilicium).

Et c'est dans cette deuxième région de polysilicium, électriquement isolée de la première région, et située au-dessus de cette première région de polysilicium, que se situent les régions de source, de drain du premier transistor ainsi que la région de substrat de ce premier transistor.

Et, ainsi, même si la première région de polysilicium est fortement dopée, résultant par exemple d'un procédé de fabrication classique utilisant un dopage in situ du premier niveau de polysilicium, ceci n'est pas gênant pour le fonctionnement du premier transistor puisque les régions actives de source, de drain ainsi que la région de canal (contenue dans la région de substrat du transistor), sont situées non pas dans cette première région de polysilicium, mais dans la deuxième région de polysilicium.

Selon un mode de réalisation, la région de substrat du premier transistor est avantageusement moins dopée que la première région de polysilicium.

Ceci permet de réduire, voire de supprimer, les fuites entre les régions de source et de drain du premier transistor.

A titre indicatif, la région de substrat du premier transistor peut comprendre du polysilicium intrinsèque, c'est-à-dire ayant un dopage inférieur à 10¹⁵ atomes/cm3 ou bien une concentration de dopants inférieure à 10¹⁷ atomes/cm3, par exemple de l'ordre de 5.10¹⁶ atomes/cm3.

La première région de polysilicium peut quant à elle avoir une concentration de dopant supérieure à 10¹⁹ atomes/cm³, ce qui peut correspondre au dopage in situ habituellement utilisé dans certains procédés CMOS à double niveau de polysilicium.

Le dopage de la région de substrat du premier transistor peut également être utilisé pour ajuster avantageusement la tension de seuil de ce premier transistor.

Ce premier transistor peut être un transistor PMOS ou bien un transistor NMOS.

Selon une première variante, le circuit intégré peut comprendre une tranchée isolante, par exemple du type tranchée peu profonde (STI : « Shallow Trench Isolation » en langue anglaise), située dans le premier substrat du circuit intégré et la première région de polysilicium peut alors être située au-dessus de cette tranchée isolante.

Selon un mode de réalisation compatible avec cette première variante, la première région de polysilicium peut déborder de la deuxième région de polysilicium dans la direction source-drain du premier transistor.

Et également dans cette direction source-drain, la deuxième région de polysilicium repose sur la première région de polysilicium par l'intermédiaire d'une première région diélectrique pouvant comporter par exemple un oxyde de grille encadré par un empilement oxyde de silicium-nitrure de silicium-oxyde de silicium.

Dans ce mode de réalisation, le contact de grille peut être alors avantageusement pris sur la partie débordante de la première région de polysilicium.

Selon un autre mode de réalisation, également compatible avec cette première variante, la première région de polysilicium déborde de la deuxième région de polysilicium dans une direction perpendiculaire à la direction source-drain du premier transistor.

Par ailleurs, dans la direction source-drain du premier transistor, la dimension de la deuxième région de polysilicium est supérieure à la dimension de la première région de polysilicium et la deuxième région de polysilicium repose sur la première région de polysilicium ainsi que sur la tranchée isolante par l'intermédiaire d'une deuxième région diélectrique, par exemple également du type oxyde de silicium-nitrure de silicium-oxyde de silicium.

On obtient alors avec ce mode de réalisation, une structure plus compacte dans laquelle le contact de grille peut alors être pris sur la partie de la première région de polysilicium débordant de la deuxième région de polysilicium dans la direction perpendiculaire à la direction source-drain.

Selon encore un autre mode de réalisation, également compatible avec cette première variante, la première région de polysilicium déborde de la deuxième région de polysilicium dans une direction perpendiculaire à la direction source-drain du premier transistor.

Par ailleurs, dans la direction source-drain du premier transistor, la dimension de la deuxième région de polysilicium est supérieure à la dimension de la première région de polysilicium et la deuxième région de polysilicium repose sur la première région de polysilicium par l'intermédiaire d'une troisième région diélectrique, par exemple un oxyde de grille, et repose également sur la tranchée isolante.

Dans une telle structure, on peut s'affranchir ainsi de l'utilisation d'un empilement oxyde de silicium-nitrure de silicium-oxyde de silicium tout en conservant une structure compacte.

Selon une deuxième variante, le circuit intégré peut comprendre une tranchée isolante située dans le premier substrat, par exemple là encore une tranchée du type tranchée peu profonde, et une couche diélectrique entourant la première région de polysilicium.

Cette première région de polysilicium entourée de sa couche diélectrique s'étend à travers la tranchée isolante jusque dans le premier substrat du circuit intégré.

La région de substrat du premier transistor repose au moins en partie sur une extrémité de la première région de polysilicium entourée de ladite couche diélectrique et les régions de source et de drain reposent sur la tranchée isolante.

Dans cette deuxième variante, la première région de polysilicium isolée du premier substrat du circuit intégré est donc une région enterrée, ce qui rend compatible une telle variante avec les procédés de fabrication des mémoires non volatiles à transistor de sélection ayant une grille enterrée.

Ainsi, lorsque le circuit intégré comprend au moins une cellule-mémoire non volatile du type à transistor de sélection ayant une grille enterrée dans le premier substrat, la première région de polysilicium peut avoir une forme analogue à celle de la grille enterrée dudit transistor de sélection.

Selon un autre mode de réalisation, le circuit intégré peut comprendre
- une couche diélectrique disposée entre la première région de polysilicium et le premier substrat (du circuit intégré), et
- un deuxième transistor MOS comportant, dans le premier substrat, une région de source, une région de drain et une région de substrat du deuxième transistor située entre les régions de source et de drain et recouverte par ladite couche diélectrique.

La première région de polysilicium comporte alors une région de grille commune au premier transistor et au deuxième transistor.

Ce mode de réalisation permet ainsi d'obtenir une structure à deux transistors, particulièrement compacte, dont l'un des transistors est un transistor isolé du premier substrat du circuit intégré et l'autre transistor est réalisé dans ce premier substrat.

Le deuxième transistor peut être un transistor NMOS ou un transistor PMOS.

Comme on l'a vu ci-avant, le premier transistor peut être également quant à lui un transistor NMOS ou un transistor PMOS.

Et, lorsque le premier transistor est un transistor NMOS et le deuxième transistor est un transistor PMOS ou lorsque le premier transistor est un transistor PMOS et le deuxième transistor un transistor NMOS, on obtient alors deux transistors complémentaires (transistors CMOS) particulièrement compacts et compatibles avec les procédés classiques de fabrication de transistors CMOS.

Selon un autre aspect il est proposé un procédé de fabrication d'un transistor MOS au sein d'un circuit intégré ayant un premier substrat.

Le procédé selon cet aspect comprend
- une formation d'une première région de polysilicium électriquement isolée du premier substrat,
- une formation d'une deuxième région de polysilicium électriquement isolée de la première région de polysilicium et du premier substrat, la première région de polysilicium étant située entre une zone du premier substrat et la deuxième région de polysilicium,
- une formation au sein de la deuxième région de polysilicium, d'une région de source et d'une région de drain située de part et d'autre d'une région de substrat du transistor,
- une formation d'au moins une zone de contact de source sur la région de source et d'au moins une zone de contact de drain sur la région de drain et
- une formation d'au moins une zone de contact de grille sur la première région de polysilicium.

Selon un mode de mise en œuvre le procédé comprend un dopage in situ de la première région de polysilicium.

Selon un mode de mise en œuvre, le procédé comprend une absence de dopage de la région de substrat ou un dopage de la région de substrat plus faible que le dopage in situ de la première région de polysilicium.

Selon un mode de mise en œuvre le procédé comprend une formation d'une tranchée isolante dans le premier substrat et une formation de la première région de polysilicium au-dessus de ladite tranchée isolante.

Selon un mode de mise en œuvre, la formation de la première région de polysilicium peut être effectuée simultanément à la réalisation de grilles de transistors de sélection de mémoires non volatiles, enterrées dans le premier substrat.

Selon un autre mode de mise en œuvre possible, la formation de la première région de polysilicium est effectuée simultanément à la formation de la grille flottante d'un transistor d'état à double grille d'une cellule-mémoire non volatile.

Selon un mode de mise en œuvre, la formation de la deuxième région de polysilicium peut être effectuée simultanément à la formation de la grille d'un transistor basse tension.

Le transistor peut être un transistor PMOS ou NMOS.

Un tel transistor MOS à double niveau de polysilicium avec la grille dans le premier niveau, peut être avantageusement utilisé pour la détection d'une ouverture d'un récipient, comme cela va être expliqué plus en détails ci-après.

Actuellement, afin de déterminer si un produit est apte à être utilisé ou vendu, il devient de plus en plus obligatoire de déterminer si le récipient contenant le produit n'a pas été ouvert, par exemple dans le but de remplacer le produit original par un produit contrefait ou de moins bonne qualité.

Une inspection visuelle du récipient ne s'avère plus suffisante.

Aussi, a-t-il été proposé d'utiliser un fil électriquement conducteur reliant deux bornes de sortie d'un circuit intégré pour détecter une non ouverture ou une ouverture du récipient correspondant respectivement à un non sectionnement ou à un sectionnement dudit fil.

Plus précisément, le circuit intégré va comparer les tensions présentes aux deux bornes de sortie pour en déduire un sectionnement ou un non sectionnement dudit fil.

Cependant, il s'avère que si le fil, une fois sectionné, a été resolidarisé, par exemple au moyen d'une soudure ou d'une colle électriquement conductrice, la comparaison des tensions aux deux bornes de sortie du circuit intégré va de nouveau correspondre à une non-ouverture du récipient alors qu'en réalité celui-ci a pu être effectivement ouvert.

Il existe donc également un besoin de pouvoir détecter non seulement un sectionnement présent du fil, mais également un sectionnement passé du fil suivi d'une resolidarisation de celui-ci par exemple par une colle conductrice ou un point de soudure, ce qui pourra alors être par exemple synonyme d'une tentative d'ouverture ou d'une ouverture d'un récipient équipé de ce fil avec resolidarisation de ce fil postérieurement à ladite ouverture.

L'utilisation d'un premier transistor tel que défini ci-avant, à double niveau de polysilicium avec la grille dans le premier niveau et isolé du substrat du circuit intégré, permet d'apporter une solution à ce problème.

Plus précisément, selon un mode de réalisation, le premier transistor est par exemple un transistor PMOS ayant sa région de source reliée à la masse et ayant une tension de seuil telle qu'il est passant lorsqu'une tension nulle est appliquée sur sa grille et bloqué en présence d'une polarisation, par exemple négative, de sa grille.

Le premier transistor PMOS est alors un transistor dit « normally on » selon une appellation bien connue de l'homme du métier.

Ainsi, il peut alors être proposé un système comprenant
- un récipient fermé,
- le circuit intégré tel que défini ci-avant et comportant ce transistor PMOS « normally on ».

Le circuit intégré possède une première borne et une deuxième borne reliées par un fil électriquement conducteur ayant une partie sectionnable et agencé pour être sectionné au niveau de sa partie sectionnable en cas d'ouverture ou de tentative d'ouverture du récipient.

Le système comporte par ailleurs un dispositif de détection configuré pour détecter un sectionnement de la partie sectionnable, le dispositif de détection comportant au sein du circuit intégré
- un premier condensateur électriquement isolé du premier substrat du circuit intégré et connecté à la première borne du circuit intégré,
- le premier transistor PMOS mentionné ci-avant, ayant sa grille connectée à la deuxième borne du circuit intégré et sa source connectée à la masse,
- un deuxième condensateur électriquement isolé du premier substrat du circuit intégré et possédant une première électrode connectée au drain du premier transistor PMOS, et
- un moyen de mesure configuré pour mesurer la tension de ladite première électrode.

Et, une tension de ladite première électrode inférieure à un seuil est alors représentative d'un sectionnement présent ou passé de ladite partie sectionnable du fil.

Cela étant, un tel système permettant la détection d'un sectionnement présent ou passé de la partie sectionnable du fil n'est pas limité à l'utilisation de ce premier transistor PMOS particulier.

En effet, d'une façon plus générale, on peut utiliser un premier transistor MOS ayant ses régions de source et de drain électriquement isolées du premier substrat (du circuit intégré), ayant sa région de grille connectée à la deuxième borne du circuit intégré et configuré pour être dans un état passant en présence d'un tension nulle appliquée sur sa grille et dans un état bloqué en présence d'une polarisation non nulle de sa région de grille.

Ainsi, plus généralement, il est également proposé un système, comprenant
- un récipient fermé,
- un circuit intégré possédant un premier substrat et une première et une deuxième bornes reliées par un fil électriquement conducteur ayant une partie sectionnable et agencé pour être sectionné au niveau de sa partie sectionnable en cas d'ouverture ou de tentative d'ouverture du récipient, et
- un dispositif de détection configuré pour détecter un sectionnement de la partie sectionnable, le dispositif de détection comportant au sein du circuit intégré,
   ○ un premier condensateur électriquement isolé du premier substrat du circuit intégré et connecté à la première borne,
   ○ un premier transistor MOS ayant ses régions de source et de drain électriquement isolées du premier substrat, ayant sa région grille connectée à la deuxième borne et configuré pour être dans un état passant en présence d'une tension nulle appliquée sur sa grille et dans un état bloqué en présence d'une polarisation non nulle de sa région de grille,
   ○ un deuxième condensateur électriquement isolé du premier substrat du circuit intégré et possédant une première électrode connectée au drain du premier transistor PMOS, et
   ○ un moyen de mesure configuré pour mesurer la tension de ladite première électrode,
- une tension de ladite première électrode inférieure à un seuil étant représentative d'un sectionnement présent ou passé de ladite partie sectionnable.

Le premier transistor MOS peut être un transistor MOS tel que défini ci-avant (ayant sa grille dans la première région de polysilicium et ses régions de source, de substrat et de drain dans la deuxième région de polysilicium), ou bien un autre transistor ayant une autre structure l'isolant du premier substrat du circuit intégré.

Selon un mode de réalisation le premier condensateur et le deuxième condensateur sont des condensateurs comportant deux électrodes en polysilicium séparées par un diélectrique et reposant sur une région isolante du circuit intégré.

Des transpondeurs passifs sans contact, notamment des transpondeurs NFC (« Near Field Communication »), par exemple des étiquettes (tags) sont bien connus de l'homme du métier.

Il s'avère particulièrement intéressant de les utiliser pour la détection d'une ouverture ou d'une tentative d'ouverture par un tiers mal intentionné, du récipient fermé contenant par exemple un produit de valeur, par exemple un flacon de parfum.

La communication champ proche, plus connue par l'homme du métier sous la dénomination anglosaxonne NFC (« Near Field Communication ») est une technologie de connectivité sans fil qui permet une communication sur une courte distance, par exemple 10 cm, entre des dispositifs électroniques, comme par exemple des cartes à puce sans contact ou des étiquettes, et des lecteurs.

Plus généralement la technologie NFC est une technologie normalisée par le consortium NFC Forum.

La technologie NFC est particulièrement adaptée pour connecter tout type de dispositif utilisateur et permet des communications rapides et faciles.

Un transpondeur sans contact est un transpondeur capable d'échanger des informations via une antenne avec un lecteur sans contact, selon un protocole de communication sans contact.

Un transpondeur NFC, qui est un transpondeur sans contact, est un transpondeur compatible avec la technologie NFC.

La technologie NFC est une plate-forme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC.

La technologie sans contact peut aussi être utilisée dans les transpondeurs RFID (Radio Frequency IDentification) compatibles avec les normes ISO 15693 et ISO 18000-3.

Lors d'une transmission d'information entre un lecteur et un transpondeur passif, le lecteur génère un champ magnétique par l'intermédiaire de son antenne qui est généralement dans les normes classiquement utilisées, une onde sinusoïdale (la porteuse) à 13,56MHz.

Pour transmettre des informations depuis le lecteur vers le transpondeur, le lecteur utilise une modulation d'amplitude de ladite porteuse.

Le transpondeur quant à lui démodule la porteuse reçue pour en déduire les données transmises depuis le lecteur.

Pour une transmission d'informations du transpondeur vers le lecteur, le lecteur génère le champ magnétique (la porteuse) sans modulation. L'antenne du transpondeur module alors le champ généré par le lecteur, en fonction des informations à transmettre. La fréquence de cette modulation correspond à une sous-porteuse de ladite porteuse. La fréquence de cette sous porteuse dépend du protocole de communication utilisé et peut être par exemple égale à 848 kHz.

Cette modulation est effectuée en modifiant la charge connectée aux bornes de l'antenne du transpondeur.

En d'autres termes, le transpondeur rétro-module l'onde issue du lecteur pour transmettre des informations et n'intègre pas, pour la transmission des informations, de moyens d'émission proprement dits, ou émetteur, capable par exemple de générer son propre champ magnétique lors de l'émission. Un tel transpondeur dépourvu d'émetteur est appelé transpondeur passif, par opposition à un transpondeur actif qui comporte un émetteur.

Généralement un transpondeur passif est dépourvu d'alimentation car il utilise l'onde issue du lecteur pour alimenter son circuit intégré.

Comme indiqué ci-avant, la transmission d'informations depuis le transpondeur passif vers le lecteur s'effectue par une modulation de charge.

En effet, en modifiant la charge aux bornes de l'antenne du transpondeur, l'impédance de sortie de l'antenne du lecteur change en raison du couplage magnétique entre les deux antennes.

Cette variation de charge effectuée lors de la modulation de charge se traduit par une modulation d'amplitude et/ou de phase du signal (tension ou courant) au niveau de l'antenne du lecteur. Une copie du courant d'antenne est générée et injectée dans la chaîne de réception du lecteur où il est démodulé et traité de façon à extraire les informations transmises.

Selon un mode de réalisation il est ainsi proposé que ledit système comprenne également un transpondeur passif sans contact configuré pour communiquer avec un lecteur via une antenne en utilisant un signal de porteuse, le transpondeur comportant le circuit intégré possédant en outre deux bornes d'antenne connectées à l'antenne.

Le circuit intégré comporte également un moyen de comparaison configuré pour comparer la tension de ladite première électrode du deuxième condensateur audit seuil, et des moyens de traitement configurés pour
- en réponse à une première commande émanant du lecteur, commander une charge du premier condensateur,
- en réponse à une deuxième commande émanant du lecteur, commander une charge du deuxième condensateur,
- en réponse à une commande d'activation émanant du lecteur, activer le moyen de mesure, et
- en réponse à une commande de lecture émanant du lecteur communiquer le résultat de ladite comparaison au lecteur.

Selon un autre aspect il est également proposé un procédé de détection d'un sectionnement ou non, présent ou passé, de la partie sectionnable du fil électriquement conducteur du système tel que défini ci-avant, comprenant
- une charge du premier condensateur,
- une charge du deuxième condensateur,
- au moins une mesure de la tension de la première électrode du deuxième condensateur, et
une analyse du résultat d'une comparaison entre ladite tension mesurée et ledit seuil.

Selon un mode de mise en œuvre, le procédé peut comprendre, afin d'effectuer une surveillance du non sectionnement du fil, et lorsque les deux condensateurs ayant été chargés une seule fois,
- plusieurs mesures de la tension de la première électrode effectuées à des instants de mesure temporellement espacés et
- plusieurs comparaisons entre ces tensions mesurées et ledit seuil,
- une tension mesurée inférieure audit seuil à un instant de mesure indiquant une partie sectionnable sectionnée audit instant de mesure ou précédemment à cet instant de mesure.

D'autres avantages et caractéristiques de l'invention apparaîtront à l'examen de la description détaillée de modes de mise en œuvre et de réalisation, nullement limitative, et des dessins annexés sur lesquels :
[Fig 1]
[Fig 2]
[Fig 3]
[Fig 4]
[Fig 5]
[Fig 6]
[Fig 7]
[Fig 8]
[Fig 9]
[Fig 10]
[Fig 11]
[Fig 12]
[Fig 13]
[Fig 14]
[Fig 15]
[Fig 16]
[Fig 17]
[Fig 18]
[Fig 19]
[Fig 20]
[Fig 21]
[Fig 22]
[Fig 23]
[Fig 24]
[Fig 25], et
[Fig 26] illustrent des modes de mise en œuvre et de réalisation de l'invention.

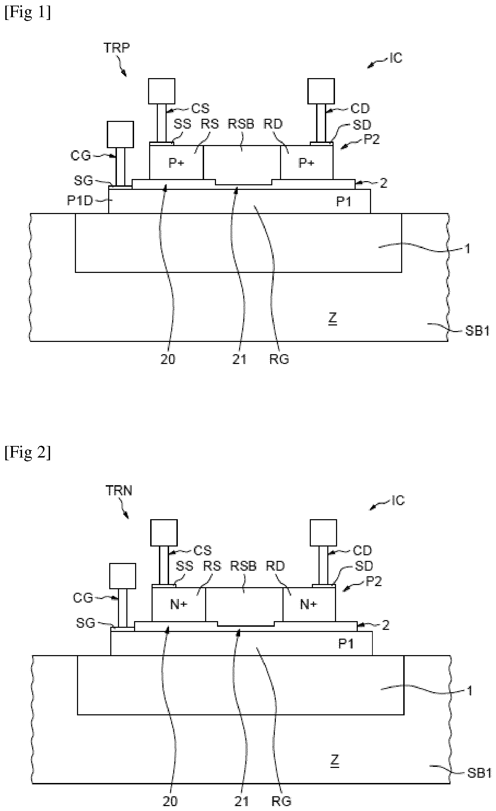

Sur la figure 1, la référence IC désigne un circuit intégré comportant un substrat SB1, dénommé dans la suite « premier substrat » de façon à se distinguer de la région de substrat RSB du premier transistor TRP dont la structure va maintenant être décrite.

Ce premier transistor TRP, qui est ici un transistor PMOS, possède une première région de polysilicium P1 reposant sur une tranchée isolante 1, du type tranchée peu profonde, ménagée dans le premier substrat SB1.

Cette première région de polysilicium P1 est donc électriquement isolée du premier substrat SB1.

Cette première région de polysilicium P1 inclut une région de grille RG du premier transistor TRP.

Le premier transistor TRP comprend également une deuxième région de polysilicium P2 électriquement isolée de la première région de polysilicium P1 par l'intermédiaire d'une première région diélectrique 2 sur laquelle elle repose.

Dans cet exemple, la première région diélectrique 2 comporte un oxyde de grille 21 encadré par deux empilements diélectriques 20 comportant par exemple chacun un empilement oxyde de silicium-nitrure de silicium-oxyde de silicium.

Puisque cette deuxième région de polysilicium P2 est électriquement isolée de la première région de polysilicium P1, et que cette première région de polysilicium P1 est électriquement isolée du premier substrat SB1, la deuxième région de polysilicium P2 est également isolée électriquement du premier substrat SB1.

La deuxième région de polysilicium P2 inclut une région de source RS, une région de substrat RSB et une région de drain RD du premier transistor TRP.

Ainsi, comme on le voit sur la figure 1, la première région de polysilicium P1 est située entre une zone Z du premier substrat SB1 et la deuxième région de polysilicium P2.

Dans cet exemple de réalisation, la première région de polysilicium P1 déborde de la deuxième région de polysilicium P2 dans la direction source-drain du premier transistor et la deuxième région de polysilicium repose, comme indiqué ci-avant, sur la première région de polysilicium par l'intermédiaire de la première région diélectrique 2.

La partie débordante P1D de la première région de polysilicium P1 permet la réalisation sur sa surface d'une zone siliciurée SG de contact de grille destinée à recevoir un contact CG de structure classique et connue.

La première région de polysilicium P1 peut être dopée assez fortement, par exemple avec une concentration de dopants supérieure ou égale à 10¹⁹ atomes/cm3.

La région de substrat du premier transistor est quant à elle moins dopée que la première région de polysilicium P1.

Ainsi, cette région de substrat RSB (à l'aplomb de l'oxyde de grille 21) peut comprendre du polysilicium intrinsèque, c'est-à-dire du polysilicium ayant une concentration de dopants inférieure ou égale à 10¹⁵ atomes/cm³. Elle pourrait être également dopée à une concentration de dopants inférieure à 10¹⁷ atomes/cm³ tout en restant bien entendu inférieure à la concentration de dopants de la première région de polysilicium P1.

Le dopage de la région de substrat RSB permet un ajustement de la tension de seuil du premier transistor TRP.

Dans cet exemple, puisque le premier transistor TRP est un transistor PMOS, les régions de source RS et de drain RD sont dopées P+ (et sont à l'aplomb des oxydes de grille 20).

Par ailleurs, de façon classique et connue, la région de source RS comporte sur sa surface supérieure une zone siliciurée SS de contact de source destinée à recevoir un contact de source CS de structure classique.

La région de drain RD comporte sur sa surface supérieure une zone siliciurée SD de contact de drain destinée à recevoir un contact de drain CD de structure classique.

Un premier transistor TRN illustré sur la figure 2 diffère simplement du premier transistor TRP de la figure 1 en ce que le transistor TRN est un transistor NMOS avec cette fois-ci les régions de source RS et de drain RD dopées N+.

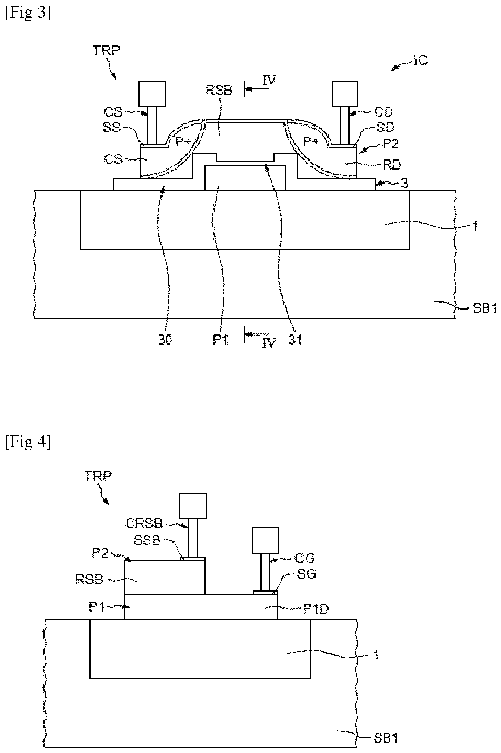

La figure 3, et la figure 4 qui est une coupe selon la ligne IV-IV de la figure 3, illustrent schématiquement un autre mode de réalisation d'un premier transistor TRP qui est là encore un transistor PMOS étant bien entendu qu'il pourrait également être un transistor NMOS en fonction du type de dopage de ses régions de source et de drain.

Dans le mode de réalisation de la figure 3, on voit que la dimension de la deuxième région de polysilicium P2 est cette fois-ci supérieure, dans la direction source-drain, à la dimension de la première région de polysilicium P1.

La deuxième région de polysilicium P2 repose cette fois-ci sur la première région de polysilicium et sur la tranchée isolante 1 par l'intermédiaire d'une deuxième région diélectrique 3. Cette deuxième région diélectrique comporte comme la première région diélectrique 2, un empilement 30 oxyde de silicium-nitrure de silicium-oxyde de silicium et un oxyde de grille 31.

Les régions de source et de drain reposent sur la région isolante par l'intermédiaire des empilements 30 tandis que la région de substrat RSB repose en partie sur la première région de polysilicium 1 par l'intermédiaire de l'oxyde de grille 31.

Et, comme illustré sur la figure 4, la première région de polysilicium P1 déborde cette fois-ci de la deuxième région de polysilicium P2 dans une direction perpendiculaire à la direction source-drain du premier transistor.

Et, c'est là encore sur cette partie débordante P1D que se situe la zone siliciurée SG de contact de grille destinée à recevoir le contact de grille CG.

La région de substrat RSB comporte également sur sa surface supérieure une zone siliciurée SSB de contact de substrat destinée à recevoir un contact de substrat CRSB.

Il convient de noter que, sur les figures 1 et 2, ce contact de substrat n'est pas représenté à des fins de simplification.

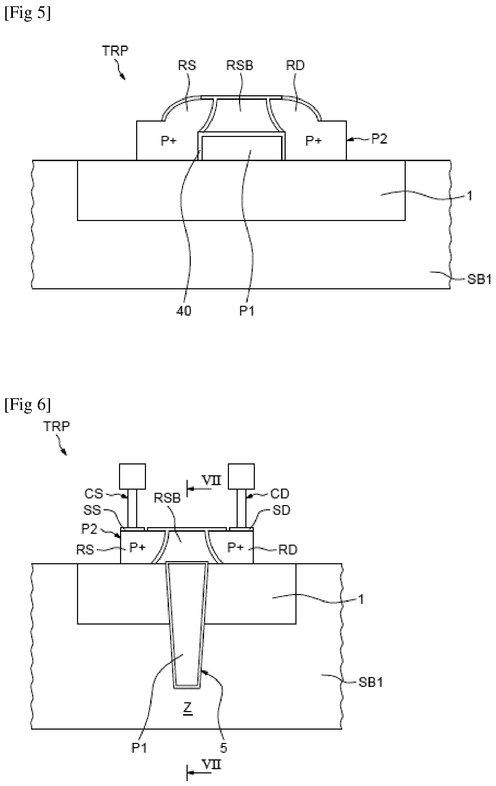

Le transistor TRP de la figure 5 diffère du transistor TRP de la figure 3 en ce que l'empilement 30 oxyde de silicium-nitrure de silicium-oxyde de silicium a été supprimé.

Et dans ce mode de réalisation, la deuxième région de polysilicium P2 repose sur la première région de polysilicium P1 par l'intermédiaire d'une troisième région diélectrique 40 qui est ici un oxyde de grille, et repose également directement sur la tranchée isolante 1 au niveau des régions de source RS et de drain RD.

Et, la première région de polysilicium P1 déborde de la deuxième région de polysilicium P2 dans une direction perpendiculaire à la direction source-drain du premier transistor d'une façon analogue à ce qui a été illustré sur la figure 4.

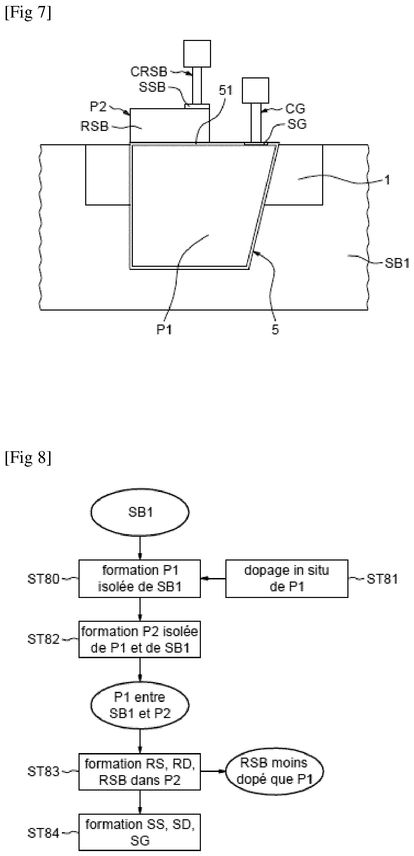

On se réfère maintenant plus particulièrement aux figures 6 et 7 qui illustrent une autre variante de réalisation d'un premier transistor MOS, qui là encore est un transistor PMOS, étant bien entendu qu'il pourrait être également un transistor NMOS en fonction du type de dopage de ses régions de source et de drain.

Là encore, le circuit intégré IC comporte une tranchée isolante 1 située dans le premier substrat SB1.

Dans cette variante de réalisation, la première région de polysilicium P1 est entourée par une couche diélectrique 5, par exemple du dioxyde de silicium.

Et, la première région de polysilicium P1 entourée de sa couche diélectrique 5 s'étend à travers la tranchée isolante 5 jusque dans le premier substrat SB1.

Par ailleurs, la deuxième région de polysilicium P2 comporte toujours la région de source RS, la région de drain RD et la région de substrat RSB située entre la région de source RS et la région de drain RD.

La région de substrat RSB du transistor TRP repose en moins en partie sur une extrémité 51 de la première région de polysilicium entourée de la couche diélectrique 5 tandis que les régions de source RS et de drain RD reposent sur la tranchée isolante 1.

Donc, également dans cette variante de réalisation, la première région de polysilicium P1 est située entre une zone Z du premier substrat et la deuxième région de polysilicium P2.

La deuxième région de polysilicium est là encore électriquement isolée de la première région de polysilicium et également électriquement isolée du premier substrat SB1.

Comme on le voit sur la figure 7 qui est une coupe selon la ligne VII-VII de la figure 6, la première région de polysilicium P1 entourée de sa couche diélectrique 5 déborde de la deuxième région de polysilicium P2 dans une direction perpendiculaire à la direction drain-source ce qui permet, comme cela a été décrit en référence à la figure 4, au contact de grille CG, de venir contacter la zone siliciurée SG.

Cette variante de réalisation est donc compatible avec un procédé de fabrication de cellules-mémoire non volatiles du type à transistor de sélection ayant une grille enterrée dans le premier substrat SB 1.

En effet, la réalisation de la première région de polysilicium enterrée peut s'effectuer simultanément à la réalisation des grilles enterrées des transistors de sélection de ces mémoires.

Et la première région de polysilicium a alors par exemple une forme analogue à celle de la grille enterrée d'un tel transistor de sélection.

En pratique le premier transistor MOS comprend sur la surface supérieure de la deuxième région de polysilicium P2, une couche de protection destinée à protéger la partie sous-jacente de la deuxième région de polysilicium P2 lors de l'étape de siliciuration permettant d'obtenir les zones siliciurées.

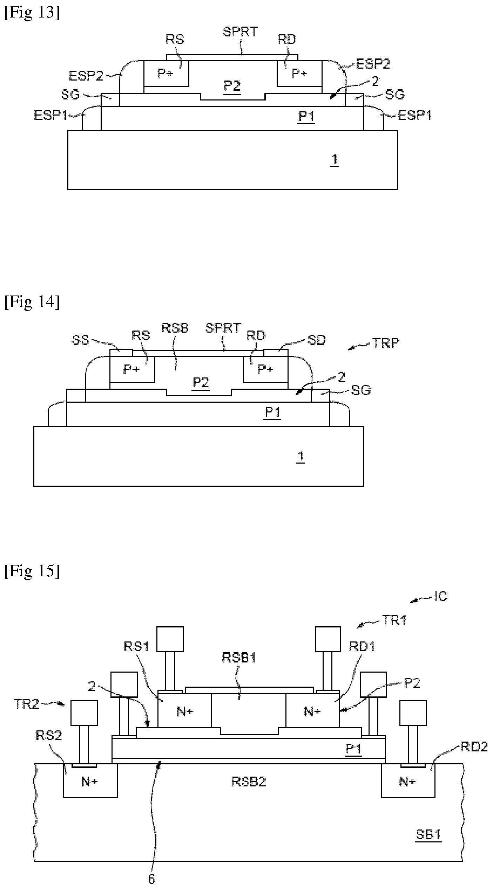

A des fins de simplification des figures 1 à 7, cette couche de protection n'est pas représentée sur ces figures, mais sera évoquée lors de la description de la figure 8 et sera représentée sur les figures 13 à 15.

On se réfère maintenant plus particulièrement à la figure 8 pour décrire un mode de mise en œuvre d'un procédé de fabrication d'un premier transistor MOS.

Dans le substrat SB1, on forme (étape ST80) la première région de polysilicium P1 isolée du premier substrat SB1.

A titre d'exemple, après avoir réalisé de façon classique la tranchée isolante 1, du type tranchée peu profonde, la formation de la première région de polysilicium P1 peut comprendre un dépôt de polysilicium suivi d'une gravure (dans le cas par exemple des modes de réalisation des figures 1 à 5), ou bien un dépôt dans une tranchée profonde suivi d'un polissage mécanochimique (dans le cas par exemple du mode de réalisation des figures 6 et 7). A cet égard, plus précisément, après avoir réalisé la tranchée 1 peu profonde, on procède à une gravure profonde à travers cette tranchée 1 de façon à réaliser la tranchée profonde, suivie d'une oxydation de cette tranchée profonde. Puis on procède au dépôt d'une couche de polysilicium de façon à remplir la tranchée et on retire le surplus de polysilicium par exemple par un polissage mécanochimique.

De façon optionnelle, il peut être prévu un dopage ST81 in situ de la première région de polysilicium si l'on utilise une étape analogue à celle appartenant à un procédé classique de fabrication CMOS.

Puis, dans l'étape ST82, on forme la deuxième région de polysilicium P2 isolée de la première région de polysilicium P1 et du premier substrat SB1.

A titre indicatif, cette formation peut comprendre tout d'abord une formation d'une région diélectrique (par exemple une croissance d'oxyde de silicium) sur la région de polysilicium formée à l'étape ST80 puis un dépôt d'un deuxième niveau de polysilicium suivi d'une gravure, ou bien dans le cas d'une première région de polysilicium enterrée, un dépôt d'un niveau de polysilicium sur la tranchée isolante suivi d'une gravure, pour former la deuxième région de polysilicium P2.

On obtient donc à ce stade la première région de polysilicium P1 entre une zone du premier substrat SB1 et la deuxième région de polysilicium P2.

Puis, on forme de façon classique et connue en soi, dans l'étape ST83 les régions de source RS et de drain RD, la région de substrat RSB étant située entre les régions de source et de drain et étant moins dopée que la première région de polysilicium P1.

Optionnellement, on peut effectuer un dopage localisé de cette région de substrat RSB de façon à ajuster la tension de seuil du transistor.

Puis, dans l'étape ST84, on forme de façon classique et connue les zones siliciurées SS, SB et SG après avoir protégé les zones non à siliciurer avec la couche de protection mentionnée ci-avant.

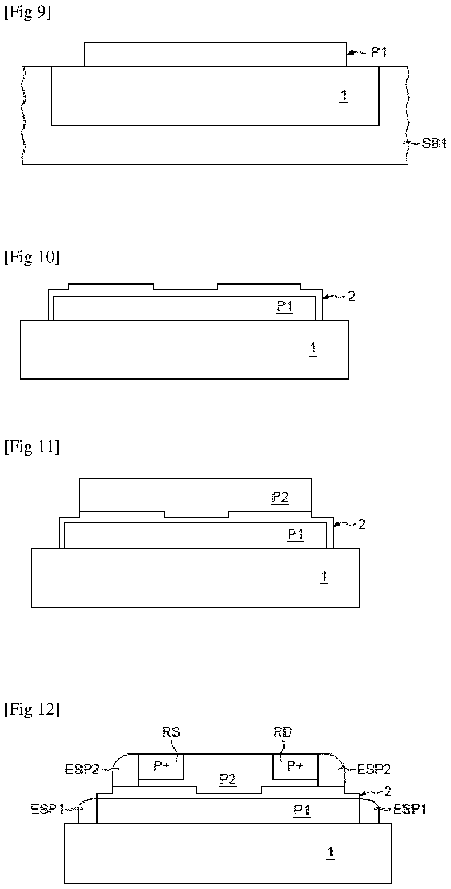

On se réfère maintenant plus particulièrement aux figures 9 à 14, qui illustrent plus en détail un mode de mise en œuvre d'un procédé de réalisation d'un transistor tel que celui décrit à la figure 1.

Sur la figure 9, après avoir réalisé de façon classique et connue la tranchée isolante 1 dans le premier substrat SB1 du circuit intégré, on forme par dépôt de polysilicium puis gravure, la première région de polysilicium P1.

La formation de cette première région de polysilicium peut par exemple être effectuée simultanément à la formation de la grille flottante d'un transistor d'état à double grille d'une cellule-mémoire non volatile.

Sur les figures 10 à 14, à des fins de simplification, le premier substrat SB1 n'est plus représenté.

Puis, comme illustré sur la figure 10, on recouvre la première région de polysilicium P1 avec la première région diélectrique 2 comportant une croissance d'oxyde de silicium et un dépôt d'un empilement d'oxyde de silicium-nitrure de silicium-oxyde de silicium. En pratique, on procède d'abord à un dépôt de l'empilement d'oxyde de silicium-nitrure de silicium-oxyde de silicium, puis on masque la zone dans laquelle on va procéder à la croissance de l'oxyde de silicium. On retire l'empilement dans cette zone puis on procède à la croissance de l'oxyde de silicium dans cette zone.

Puis, comme illustré sur la figure 11, on forme, par dépôt d'un deuxième niveau de polysilicium et gravure, la deuxième région de polysilicium P2 qui repose sur une partie de la région diélectrique 2.

La formation de cette deuxième région de polysilicium peut par exemple être effectuée simultanément à la formation de la grille d'un transistor basse tension d'une circuiterie de mémoire par exemple, c'est-à-dire un transistor capable de supporter une tension grille-source par exemple inférieure ou égale à 3 volts.

A la figure 12, on réalise de façon classique et connue les régions latérales isolantes ou espaceurs ESP1 sur les flancs de la première région P1 et les espaceurs ESP2 sur les flancs de la deuxième région P2.

Puis, on procède à une implantation localisée de la deuxième région de polysilicium P2 de façon à former les régions de source RS et de drain RD.

On procède ensuite au dépôt (figure 13), sur la surface supérieure de la deuxième région de polysilicium P2, de la couche de protection SPRT , mentionnée ci-avant, destinée à protéger la partie sous-jacente de la deuxième région de polysilicium P2 lors de l'étape de siliciuration qui est décrite à la figure 14.

Plus précisément, lors de cette étape de siliciuration, on réalise de façon classique et connue les zones siliciurées SS, SG et SD.

On se réfère maintenant plus particulièrement à la figure 15 qui illustre un exemple de réalisation de deux transistors TR1 et TR2.

Le premier transistor TR1 est un transistor ayant une structure analogue à celle qui a été décrite en référence aux figures 1 et 2.

Dans cet exemple, le premier transistor TR1 est un transistor NMOS mais bien entendu, le transistor TR1 pourrait être également un transistor PMOS moyennant un dopage P+ des régions de source RS1 et de drain RD1.

Sur cette figure, on a également représenté la couche de protection anti-siliciuration qui recouvre la région de substrat RSB1 du transistor TR1 ainsi que partiellement les régions de source RS1 et de drain RD1.

La première région de polysilicium P1 du premier transistor TR1 repose sur le premier substrat SB1 du circuit intégré IC par l'intermédiaire d'une couche diélectrique 6, par exemple un oxyde de grille.

Et, le circuit intégré IC comporte alors un deuxième transistor TR2, ici un transistor NMOS.

Ce deuxième transistor TR2 comporte, dans le premier substrat SB1, une région de source RS2, une région de drain RD2 et une région de substrat RSB2 entre les régions de source et de drain, cette région de substrat RSB2 étant recouverte par la couche diélectrique 2.

Et, la première région de polysilicium P1 comporte une région de grille commune au premier transistor TR1 et au deuxième transistor TR2.

Bien entendu, le deuxième transistor TR2 pourrait être un transistor PMOS si les régions de source RS2 et de drain RD2 étaient dopées P+.

On voit donc que si l'un des deux transistors est un transistor NMOS et l'autre un transistor PMOS, alors on obtient deux transistors complémentaires de structure compacte.

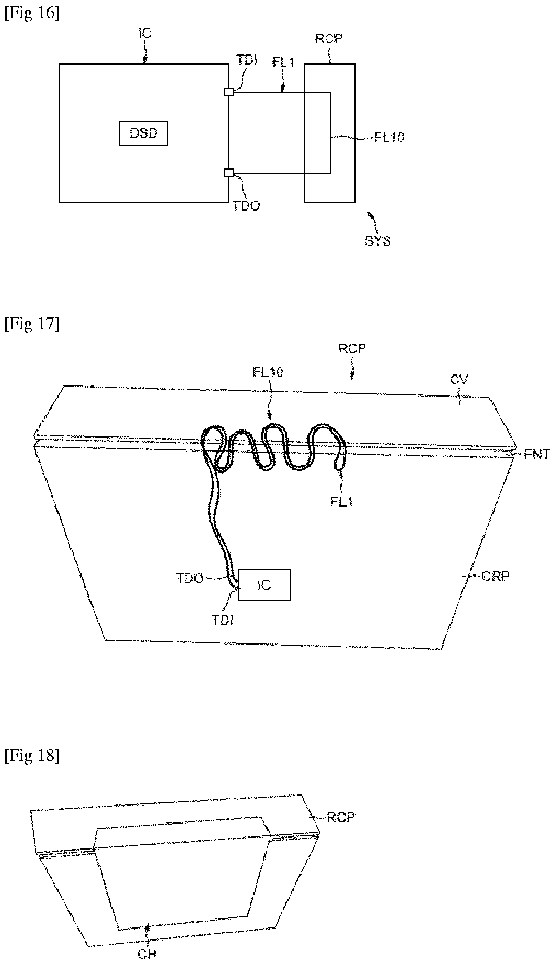

On se réfère maintenant plus particulièrement aux figures 16 et suivantes qui illustrent schématiquement des modes de réalisation et de mise en œuvre d'un système SYS permettant une détection d'une ouverture ou d'une tentative d'ouverture d'un récipient fermé.

Sur la figure 16, le système SYS comporte un récipient fermé RCP et un circuit intégré possédant une première borne TDI et une deuxième borne TDO reliées par un fil électriquement conducteur FL1.

Ce fil a une partie sectionnable FL10 et est agencé pour être sectionné au niveau de sa partie sectionnable en cas d'ouverture ou de tentative d'ouverture du récipient RCP.

Le système SYS comporte également un dispositif de détection DSD, incorporé ici au sein du circuit intégré IC, et configuré pour détecter un sectionnement présent ou passé de la partie sectionnable FL10 du fil FL1.

Comme illustré sur la figure 17, le récipient RCP peut être une boîte comportant un corps CRP fermé par un couvercle CV ménageant avec le corps CRP une fente FNT.

Bien entendu, ceci n'est qu'un exemple et le récipient RCP peut prendre toute forme appropriée au contenu du récipient. Le récipient peut être par exemple une bouteille de vin ou d'alcool fermée par un bouchon.

Dans l'exemple de la figure 17, le fil électriquement conducteur FL1, entouré d'une gaine isolante, serpente de façon à s'étendre alternativement sur le couvercle CV et sur le corps CRP.

Cette partie en forme de serpentin FL10 forme la partie sectionnable du fil électriquement conducteur.

En effet, lors de l'ouverture du couvercle CV, le fil FL1 sera sectionné au niveau de la partie sectionnable FL10.

Bien entendu, le dessin de la figure 17 n'est pas à l'échelle et l'homme du métier saura choisir le diamètre adéquat pour le fil FL1 de façon à garantir un sectionnement de celui-ci lors de l'ouverture du couvercle CV.

Le circuit intégré IC est par exemple fixé sur une paroi du corps CRP.

Puis, une fois ce montage effectué, l'ensemble est recouvert d'un cache CH comme illustré très schématiquement sur la figure 18.

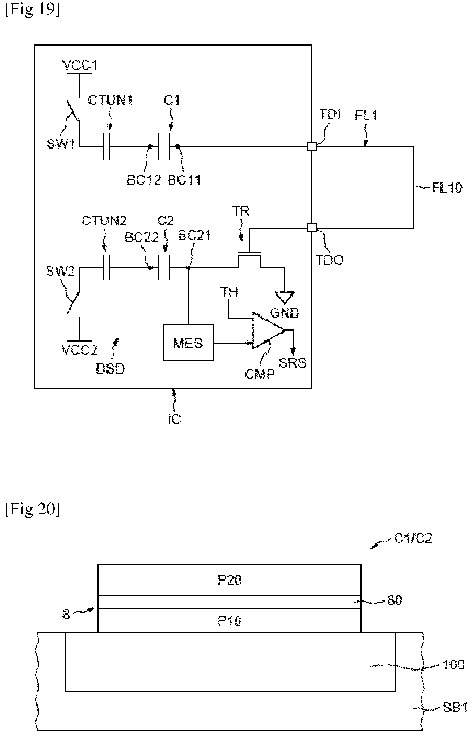

On se réfère maintenant plus particulièrement à la figure 19 qui illustre un exemple de réalisation d'un dispositif de détection DSD.

Le dispositif DSD comporte ici un premier condensateur C1, électriquement isolé du premier substrat SB1 du circuit intégré et possédant une première électrode BC11 connectée à la première borne TDI du circuit intégré.

Dans cet exemple de réalisation, la deuxième électrode BC12 du premier condensateur C1 est reliée à une tension d'alimentation VCC1 par l'intermédiaire d'un premier condensateur auxiliaire CTUN1 et d'un premier interrupteur commandable SW1.

Le dispositif DSD comporte également un premier transistor MOS TR ayant ses régions de source et de drain électriquement isolées du premier substrat SB1 et ayant sa région de grille connectée à la deuxième borne TDO du circuit intégré.

D'une façon générale, le premier transistor TR est configuré pour être dans un état passant en présence d'une tension nulle appliquée sur sa grille et dans un état bloqué en présence d'une polarisation non nulle de sa région de grille.

A titre d'exemple non limitatif, le premier transistor TR peut être un transistor PMOS tel que celui décrit en référence aux figures 1 et 3 à 7.

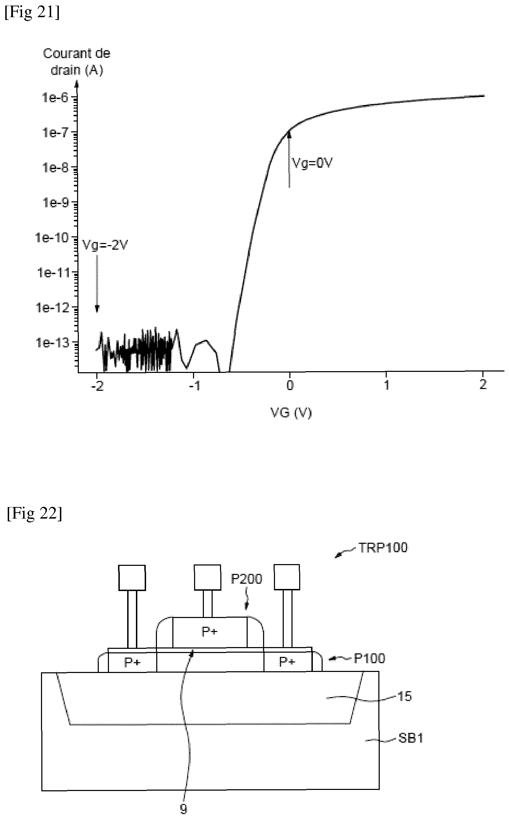

Dans ce cas, le premier transistor PMOS TR a par exemple sa source reliée à la masse GND et est configuré pour, comme illustré sur la figure 21, être bloqué en présence d'une polarisation Vg négative (par exemple -2 volts) appliquée sur sa grille et passant en présence d'une tension Vg nulle appliquée sur sa grille.

Le premier transistor TR est alors normalement passant (« normally on »)

Pour obtenir une telle configuration, la tension de seuil de ce premier transistor PMOS TR est négative et par exemple de l'ordre de - 600 à -700 mV.

Le dispositif DSD comporte également un deuxième condensateur C2 électriquement isolé du premier substrat SB1 du circuit intégré.

Ce deuxième condensateur C2 possède une première électrode BC21 connectée au drain du premier transistor TR.

Le deuxième condensateur C2 possède une deuxième électrode BC22 connectée à une tension d'alimentation VCC2 par l'intermédiaire d'un deuxième condensateur auxiliaire CTUN2 et d'un deuxième interrupteur commandable SW2.

Le dispositif de détection DSD comporte par ailleurs un moyen de mesure MES configuré pour mesurer la tension de la première électrode BC21.

Comme on le verra plus en détail ci-après, une tension de la première électrode inférieure à un seuil TH est représentative d'un sectionnement présent ou passé de la partie sectionnable FL10 du fil FL1.

A cet égard, dans ce mode de réalisation, le circuit intégré IC comporte un moyen de comparaison CMP configuré pour comparer la tension de la première électrode délivrée par le moyen de mesure MES au seuil TH et délivrer un signal SRS représentatif du résultat de la comparaison.

Ce signal SRS peut être un signal ayant un état haut lorsque la tension mesurée est inférieure au seuil TH et un état bas lorsque la tension mesurée est supérieure au seuil TH.

Bien entendu, l'inverse est possible.

Un exemple de réalisation permettant d'obtenir des condensateurs C1/C2 électriquement isolés du premier substrat SB1 est illustré schématiquement sur la figure 20.

On voit sur cette figure que le premier condensateur C1 et le deuxième condensateur C2 sont des condensateurs comportant deux électrodes P10 et P20 en polysilicium, séparés par un diélectrique 8 comportant par exemple un empilement 80 du type oxyde de silicium-nitrure de silicium-oxyde de silicium.

Ces condensateurs reposent sur une tranchée isolante 100, par exemple du type tranchée peu profonde, ménagée dans le premier substrat SB1.

Avant de revenir en détail sur le fonctionnement du système SYS, il convient de noter ici que, comme indiqué ci-avant, un transistor PMOS TRP tel que celui décrit en référence aux figures 1 et 3 à 7, n'est pas le seul transistor possible qui puisse être utilisé.

En effet, tout transistor ayant ses régions de source et de drain électriquement isolées du premier substrat et configuré pour être dans un état passant en présence d'une tension nulle appliquée sur sa grille et dans un état bloqué en présence d'une polarisation non nulle de sa région de grille, convient.

Ce peut être par exemple le cas d'un transistor TRP100 tel que celui illustré sur la figure 22.

Ce transistor TRP100 est également un transistor PMOS à double niveau de polysilicium dont la première région de polysilicium P100 repose sur une tranchée isolante 15 du type tranchée peu profonde et dont la deuxième région de polysilicium P200 repose sur la première région de polysilicium P100 par l'intermédiaire d'un oxyde de grille 9.

Mais, contrairement au transistor TRP de la figure 1 par exemple, ce transistor TRP100 a sa région de grille située dans la deuxième région de polysilicium et ses régions de source et de drain située dans la première région de polysilicium.

Par rapport à un tel transistor TRP100, un transistor TRP tel que celui décrit en référence aux figures 1 et 3 à 7 est plus avantageux car il présente moins de fuites entre les régions de source et de drain puisque celles-ci sont disposées dans la deuxième région de polysilicium dont la région de substrat est soit du polysilicium intrinsèque soit faiblement dopée.

Il serait également possible dans le cas où le substrat est un substrat du type silicium sur isolant (SOI : Silicon On Insulator) comportant un substrat porteur surmonté d'une couche isolante enterrée connue par l'homme du métier sous la dénomination anglosaxonne BOX (Burried OXyde) elle-même surmontée d'un film semiconducteur, de disposer un transistor MOS dans et sur le film semiconducteur. Celui-ci serait alors électriquement isolé du substrat porteur du circuit intégré par l'intermédiaire de la couche enterrée BOX.

Bien entendu, alors qu'il est généralement plus aisé de prévoir comme transistor TR un transistor PMOS, l'utilisation d'un transistor NMOS n'est pas exclue.

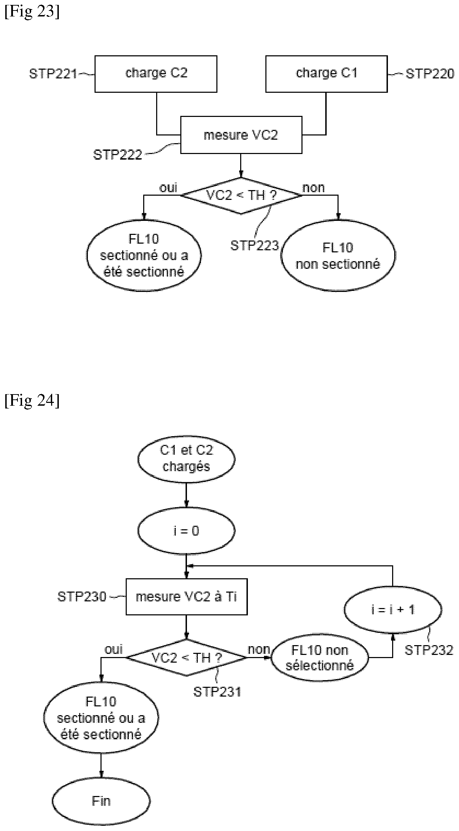

On se réfère maintenant plus particulièrement à la figure 23 pour décrire le fonctionnement du système SYS.

Dans une étape STP 220, on charge le premier condensateur C1.

Cette charge s'effectue en fermant l'interrupteur SW1 de façon à relier le premier condensateur auxiliaire CTUN1 à la tension d'alimentation VCC1.

Un rôle du premier condensateur auxiliaire CTUN1 est de permettre une injection de charges dans le premier condensateur C1 par effet Fowler-Nordheim ou par un phénomène d'injection d'électrons chauds.

L'épaisseur de la couche diélectrique du premier condensateur auxiliaire CTUN1, par exemple 65-95 angströms, est avantageusement inférieure à celle du premier condensateur C1 pour permettre de programmer la structure capacitive sans utiliser une trop forte tension.

La couche diélectrique du premier condensateur C1, épaisse car utilisant un empilement oxyde de silicium-nitrure de silicium-oxyde de silicium, permet d'avoir une structure capacitive bien isolée du premier substrat SB1. Une telle épaisseur, par exemple 150-200 angströms, offre une très grande rétention des charges, typiquement de l'ordre de deux dizaines d'années, et évite le risque de fuite sur le premier condensateur auxiliaire CTUN1.

Le premier condensateur C1, une fois chargé, présente alors au niveau de sa première électrode BC11 une tension, par exemple négative et égale à -2 volts.

Dans l'étape STP221, on charge le deuxième condensateur C2 en reliant cette fois-ci le deuxième condensateur auxiliaire CTUN2 à la tension d'alimentation VCC2 par l'intermédiaire du premier interrupteur SW2 fermé.

La fonction du deuxième condensateur auxiliaire CTUN2 est analogue à celle du premier condensateur CTUN1.

Une fois chargé, la tension VC2 de la première électrode BC21 du deuxième condensateur C2 est par exemple une tension positive égale à 2 volts.

Cette tension VC2 est mesurée dans l'étape STP222 par le moyen de mesure MES.

A cet égard, le moyen de mesure MES peut être par exemple réalisé par un transistor MOS dont la grille est reliée à l'électrode BC21, dont la source est reliée à la masse et dont le drain est relié à une source de courant permettant une conversion courant-tension du courant de drain de ce transistor.

Le nœud BC21 n'est donc pas relié au premier substrat SB1 et pour éviter autant que possible les fuites de grille, on utilisera de préférence un transistor MOS haute tension ayant par exemple un oxyde de grille de l'ordre de 200 angströms.

Si la partie sectionnable FL10 du fil FL1 n'est pas sectionnée, alors le transistor TR est bloqué car sa tension de grille est égale à -2 volts.

En conséquence, le deuxième condensateur reste chargé et si l'on choisit un seuil TH égal par exemple à 1 volt, la comparaison effectuée dans l'étape STP223 montre que cette tension VC2 est supérieure au seuil TH, ce qui signifie que la partie sectionnable FL10 n'est pas sectionnée.

Par contre, si la partie FL10 du fil est sectionnée, alors la tension de grille du transistor TR est nulle ce qui rend passant ce transistor TR et relie donc l'électrode BC21 à la masse GND.

Il s'ensuit donc une décharge du deuxième condensateur C2 et par conséquent une chute de la tension VC2.

Celle-ci devient alors inférieure au seuil TH ce qui est représentatif d'un sectionnement de la partie sectionnable FL10.

Il convient de noter qu'une tension VC2 inférieure au seuil TH est également représentative d'un sectionnement passé de la partie sectionnable FL10 suivi d'une reconstitution, par exemple par point de soudure, de cette partie sectionnable.

En effet, dès que le fil a été sectionné, la tension de grille du transistor devient nulle et celui-ci devient passant déchargeant le deuxième condensateur C2 et faisant chuter la tension VC2 en dessous du seuil TH.

Et, même si le fil est reconstitué, le condensateur C2 reste déchargé.

Il est également possible, comme illustré schématiquement sur la figure 24, de surveiller, à des intervalles temporels, réguliers ou non, l'état de la partie sectionnable du fil.

En effet, une fois que les condensateurs C1 et C2 ont été chargés, on peut effectuer, dans l'étape STP230, une première mesure de la tension VC2 à l'instant T0. Puis, on compare dans l'étape STP231, la tension VC2 au seuil.

Si cette tension est inférieure au seuil, alors cela signifie que la partie sectionnable est sectionnée ou a été sectionnée.

Si la tension VC2 est supérieure au seuil, cela signifie que la partie sectionnable FL10 n'a jamais été sectionnée.

Et, on peut alors procéder à la répétition des étapes STP230 et STP231 à des instants de mesure Ti temporellement espacés (représentés par l'incrémentation de l'indice i dans l'étape STP232).

Et, une tension mesurée inférieure au seuil TH à un instant de mesure Ti indique alors que la partie sectionnable du fil est soit sectionnée lors de cet instant de mesure ou a été sectionnée précédemment à cet instant de mesure.

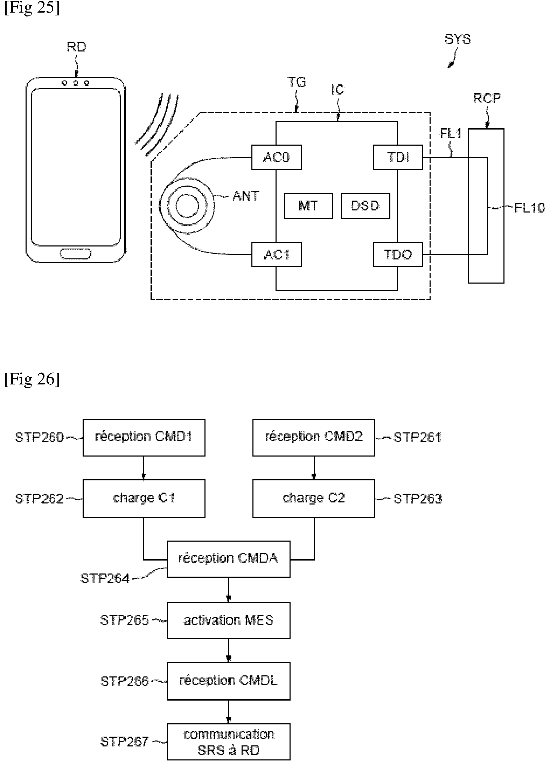

Il est particulièrement avantageux, comme illustré sur la figure 25, d'utiliser un transpondeur passif en combinaison avec un lecteur pour détecter le sectionnement présent ou passé du fil FL1.

A cet égard, sur la figure 25, le système SYS comporte en outre un transpondeur passif sans contact TG, par exemple une étiquette (Tag).

Le transpondeur passif TG est configuré pour communiquer avec un lecteur RD, par exemple un téléphone mobile cellulaire ayant une fonction de lecteur sans contact, via une antenne ANT en utilisant un signal de porteuse ayant une fréquence par exemple égale à 13,56 mhz.

Le transpondeur passif sans contact TG est ici un transpondeur capable de communiquer selon un protocole de communication sans contact utilisant par exemple la technologie de communication champ proche (NFC).

Ce transpondeur peut être également un transpondeur RFID utilisant cette technologie NFC.

Le transpondeur TG comprend le circuit intégré IC qui peut être par exemple un circuit intégré de la famille ST25 commercialisé par la société STMicroelectronics.

Outre les deux bornes TDI et TDO déjà décrites, le circuit intégré comporte deux bornes d'antenne AC0 et AC1 respectivement connectées aux deux bornes de l'antenne ANT.

Le circuit IC comporte également des moyens de traitement MT, comportant par exemple un circuit de récupération d'énergie, un microprocesseur et/ou une logique câblée ainsi qu'une mémoire.

Les moyens de traitement sont configurés pour délivrer une tension d'alimentation à l'ensemble du circuit intégré à partir du champ magnétique reçu du lecteur et traiter les informations reçues du lecteur et rétromoduler le signal de porteuse en vue de la transmission d'informations vers le lecteur.

Plus précisément, comme illustré sur la figure 26, les moyens de traitement MT sont configurés pour
- en réponse à une première commande CMD1 émanant (étape STP260) du lecteur, commander (étape STP262) une charge du premier condensateur C1,
- en réponse à une deuxième commande CMD2 émanant (étape STP261) du lecteur, commander (étape STP263) une charge du deuxième condensateur C2,
- en réponse à une commande d'activation CMDA émanant (étape STP264) du lecteur, activer (étape STP265) le moyen de mesure et,
- en réponse à une commande de lecture émanant (étape STP266) du lecteur, communiquer (étape STP267) le résultat SRS de ladite comparaison au lecteur RD.

## Revendications

1. Système, comprenant un circuit intégré comportant
- un premier substrat (SB1) et
- au moins un premier transistor MOS (TRP) possédant une première région de polysilicium (P1) électriquement isolée du premier substrat et incluant une région de grille (RG), une deuxième région de polysilicium (P2) électriquement isolée de la première région de polysilicium (P1) et du premier substrat (SB1) et incluant une région de source (RS), une région de substrat (RSB) et une région de drain (RD) dudit premier transistor, la première région de polysilicium (P1) étant située entre une zone (Z) du premier substrat (SB1) et la deuxième région de polysilicium (P2), dans lequel le premier transistor (TRP) est un transistor PMOS,
- le premier transistor PMOS (TRP) a sa région de source reliée à la masse et a une tension de seuil telle qu'il passant lorsqu'une tension nulle est appliquée sur sa grille, et bloqué en présence d'une polarisation négative de sa grille, et dans lequel le système comprend :
- un récipient fermé (RCP),
- le circuit intégré (IC) possédant une première et une deuxième bornes (TDI, TDO) reliées par un fil électriquement conducteur (FL1) ayant une partie sectionnable (FL10) et agencé pour être sectionné au niveau de sa partie sectionnable en cas d'ouverture ou de tentative d'ouverture du récipient, et
- un dispositif (DSD) de détection configuré pour détecter un sectionnement de la partie sectionnable, le dispositif de détection comportant au sein du circuit intégré, un premier condensateur électriquement isolé du premier substrat du circuit intégré et connecté à la première borne, le premier transistor PMOS ayant sa grille connectée à la deuxième borne et sa source connectée à la masse, un deuxième condensateur électriquement isolé du premier substrat du circuit intégré et possédant une première électrode connectée au drain du premier transistor PMOS, et un moyen de mesure configuré pour mesurer la tension (VC2) de ladite première électrode,
- une tension de ladite première électrode inférieure à un seuil étant représentative d'un sectionnement présent ou passé de ladite partie sectionnable.

2. Système selon la revendication 1, dans lequel la région de substrat (RSB) du premier transistor est moins dopée que la première région de polysilicium (P1).

3. Système selon la revendication 1 ou 2, dans lequel la région de substrat (RSB) du premier transistor comprend du polysilicium intrinsèque ou a une concentration de dopants inférieure à 10¹⁷ atomes/cm³.

4. Système selon l'une des revendications précédentes, dans lequel la première région de polysilicium (P1) a une concentration de dopants supérieure à 10¹⁹ atomes/cm³.

5. Système selon l'une des revendications précédentes, dans lequel le circuit intégré comprend une tranchée isolante (1) située dans le premier substrat, et la première région de polysilicium (P1) est située au-dessus de cette tranchée isolante.

6. Système selon la revendication 5, dans lequel, dans la direction source-drain du premier transistor, la première région de polysilicium (P1) déborde de la deuxième région de polysilicium (P2) et la deuxième région de polysilicium repose sur la première région de polysilicium par l'intermédiaire d'une première région diélectrique.

7. Système selon la revendication 5, dans lequel
- la première région de polysilicium (P1) déborde de la deuxième région de polysilicium dans une direction perpendiculaire à la direction source-drain du premier transistor, et
- dans la direction source-drain du premier transistor, la dimension de la deuxième région de polysilicium (P2) est supérieure à la dimension de la première région de polysilicium (P1), et la deuxième région de polysilicium repose sur la première région de polysilicium et sur la tranchée isolante par l'intermédiaire d'une deuxième région diélectrique.

8. Système selon la revendication 5, dans lequel
- la première région de polysilicium (P1) déborde de la deuxième région de polysilicium dans une direction perpendiculaire à la direction source-drain du premier transistor, et
- dans la direction source-drain du premier transistor, la dimension de la deuxième région de polysilicium (P2) est supérieure à la dimension de la première région de polysilicium, et la deuxième région de polysilicium repose sur la première région de polysilicium par l'intermédiaire d'une troisième région diélectrique et repose également sur la tranchée isolante.

9. Système selon l'une des revendications 1 à 4, dans lequel le circuit intégré comprend une tranchée isolante (1) située dans le premier substrat et une couche diélectrique (5) entourant la première région de polysilicium (P1), la première région de polysilicium entourée de sa couche diélectrique s'étendant à travers la tranchée isolante (1) jusque dans le premier substrat (SB1), la région de substrat (RSB) du premier transistor reposant au moins en partie sur une extrémité (51) de la première région de polysilicium entourée de ladite couche diélectrique et les régions de source et de drain reposant sur la tranchée isolante.

10. Système selon la revendication 9, dans lequel le circuit intégré (IC) comprend au moins une cellule-mémoire non volatile du type à transistor de sélection ayant une grille enterrée dans le premier substrat, et la première région de polysilicium a une forme analogue à celle de la grille enterrée dudit transistor de sélection.

11. Système selon l'une des revendications 1 à 4, dans lequel le circuit intégré comprend
- une couche diélectrique (6) disposée entre la première région de polysilicium et le premier substrat, et
- un deuxième transistor MOS (TR2) comportant, dans le premier substrat, une région de source, une région de drain et une région de substrat entre les régions de source et de drain et recouverte par ladite couche diélectrique, la première région de polysilicium comportant une région de grille commune au premier transistor (TR1) et au deuxième transistor (TR2).

12. Système selon la revendication 11, dans lequel le deuxième transistor (TR2) est un transistor NMOS ou un transistor PMOS.

13. Système selon l'une des revendications précédentes, dans lequel le premier condensateur (C1) et le deuxième condensateur (C2) sont des condensateurs comportant deux électrodes en polysilicium séparées par un diélectrique et reposant sur une région isolante du circuit intégré.

14. Système selon l'une des revendications précédentes, comprenant en outre un transpondeur passif sans contact (TG) configuré pour communiquer avec un lecteur (RD) via une antenne (ANT) en utilisant un signal de porteuse, le transpondeur (TG) comportant le circuit intégré (IC) possédant deux bornes d'antenne (AC0, AC1) connectées à l'antenne, le circuit intégré comportant un moyen de comparaison configuré pour comparer la tension de ladite première électrode audit seuil, et des moyens de traitement (MT) configurés pour
- en réponse à une première commande émanant du lecteur, commander une charge du premier condensateur,
- en réponse à une deuxième commande émanant du lecteur, commander une charge du deuxième condensateur,
- en réponse à une commande d'activation émanant du lecteur, activer le moyen de mesure, et
- en réponse à une commande de lecture émanant du lecteur communiquer le résultat de ladite comparaison.

15. Procédé de détection d'un sectionnement ou non, présent ou passé, de la partie sectionnable du fil électriquement conducteur du système selon l'une des revendications précédentes, comprenant une charge du premier condensateur (C1), une charge du deuxième condensateur (C2) et au moins une mesure de la tension (VC2) de la première électrode du deuxième condensateur, et une analyse du résultat d'une comparaison entre ladite tension mesurée et ledit seuil.

16. Procédé selon la revendication 15, comprenant, les deux condensateurs ayant été chargés une seule fois, plusieurs mesures de la tension de la première électrode effectuées à des instants de mesure (Ti) temporellement espacés et plusieurs comparaisons entre ces tensions mesurées et ledit seuil, une tension mesurée inférieure audit seuil à un instant de mesure indiquant une partie sectionnable sectionnée audit instant de mesure ou précédemment à cet instant de mesure.

## Patentansprüche

1. System, das eine integrierte Schaltung enthält, die Folgendes umfasst:
- ein erstes Substrat (SB1) und
- mindestens einen ersten MOS-Transistor (TRP), der einen ersten Polysiliziumbereich (P1), der vom ersten Substrat elektrisch isoliert ist und einen Gate-Bereich (RG) einschließt, und einen zweiten Polysiliziumbereich (P2) besitzt, der von dem ersten Polysiliziumbereich (P1) und dem ersten Substrat (SB1) elektrisch isoliert ist und einen Source-Bereich (RS), einen Substratbereich (RSB) und einen Drain-Bereich (RD) des ersten Transistors einschließt, wobei sich der erste Polysiliziumbereich (P1) zwischen einer Zone (Z) des ersten Substrats (SB1) und des zweiten Polysiliziumbereichs (P2) befindet, wobei der erste Transistor (TRP) ein PMOS-Transistor ist,
- wobei der erste PMOS-Transistor (TRP) seinen Source-Bereich mit der Masse verbunden hat und eine derartige Schwellenspannung aufweist, dass er durchschaltet, wenn eine Nullspannung an sein Gate angelegt wird, und bei einer negativen Vorspannung seines Gates sperrt, und wobei das System Folgendes umfasst:
- einen geschlossenen Behälter (RCP),
- wobei die integrierte Schaltung (IC) einen ersten und einen zweiten Anschluss (TDI, TDO) besitzt, die durch einen elektrisch leitenden Draht (FL1) verbunden sind, der einen abtrennbaren Teil (FL10) aufweist und so angeordnet ist, dass er, beim Öffnen oder Versuch des Öffnens des Behälters, an seinem abtrennbaren Teil durchtrennt wird, und
- eine Detektionsvorrichtung (DSD), die so konfiguriert ist, dass sie eine Abtrennung des abtrennbaren Teils detektiert, wobei die Detektionsvorrichtung innerhalb der integrierten Schaltung einen ersten Kondensator, der vom ersten Substrat der integrierten Schaltung elektrisch isoliert und mit dem ersten Anschluss verbunden ist, wobei der erste PMOS-Transistor sein Gate mit dem zweiten Anschluss verbunden hat und seine Source mit der Masse verbunden hat, einen zweiten Kondensator, der vom ersten Substrat der integrierten Schaltung elektrisch isoliert ist und eine erste Elektrode aufweist, die mit dem Drain des ersten PMOS-Transistors verbunden ist, und ein Messmittel umfasst, das so konfiguriert ist, dass es die Spannung (VC2) der ersten Elektrode misst,
- wobei eine Spannung der ersten Elektrode unterhalb eines Schwellenwerts repräsentativ für eine vorhandene oder vergangene Abtrennung des abtrennbaren Teils ist.

2. System nach Anspruch 1, wobei der Substratbereich (RSB) des ersten Transistors weniger dotiert ist als der erste Polysiliziumbereich (P1).

3. System nach Anspruch 1 oder 2, wobei der Substratbereich (RSB) des ersten Transistors intrinsisches Polysilizium umfasst oder eine Dotiermittelkonzentration von weniger als 10¹⁷ Atomen/cm³ aufweist.

4. System nach einem der vorhergehenden Ansprüche, wobei der erste Polysiliziumbereich (P1) eine Dotiermittelkonzentration von mehr als 10¹⁹ Atomen/cm³ aufweist.

5. System nach einem der vorhergehenden Ansprüche, wobei die integrierte Schaltung einen Isoliergraben (1) umfasst, der sich im ersten Substrat befindet, und der erste Polysiliziumbereich (P1) sich oberhalb des Isoliergrabens befindet.

6. System nach Anspruch 5, wobei in Source-Drain-Richtung des ersten Transistors der erste Polysiliziumbereich (P1) über den zweiten Polysiliziumbereich (P2) hinausragt und der zweite Polysiliziumbereich über einen ersten dielektrischen Bereich auf dem ersten Polysiliziumbereich aufliegt.

7. System nach Anspruch 5, wobei
- der erste Polysiliziumbereich (P1) über den zweiten Polysiliziumbereich in einer Richtung senkrecht zur Source-Drain-Richtung des ersten Transistors hinausragt, und
- in der Source-Drain-Richtung des ersten Transistors die Abmessung des zweiten Polysiliziumbereichs (P2) größer ist als die Abmessung des ersten Polysiliziumbereichs (P1), und der zweite Polysiliziumbereich über einen zweiten dielektrischen Bereich auf dem ersten Polysiliziumbereich und dem Isoliergraben aufliegt.

8. System nach Anspruch 5, wobei
- der erste Polysiliziumbereich (P1) über den zweiten Polysiliziumbereich in einer Richtung senkrecht zur Source-Drain-Richtung des ersten Transistors hinausragt, und
- in der Source-Drain-Richtung des ersten Transistors die Abmessung des zweiten Polysiliziumbereichs (P2) größer ist als die Abmessung des ersten Polysiliziumbereichs, und der zweite Polysiliziumbereich über einen dritten dielektrischen Bereich auf dem ersten Polysiliziumbereich aufliegt und ebenfalls auf dem Isoliergraben aufliegt.

9. System nach einem der Ansprüche 1 bis 4, wobei die integrierte Schaltung einen Isoliergraben (1), der sich im ersten Substrat befindet, und eine dielektrische Schicht (5) umfasst, die den ersten Polysiliziumbereich (P1) umgibt, wobei sich der erste Polysiliziumbereich, der von seiner dielektrischen Schicht umgeben ist, durch den Isoliergraben (1) bis in das erste Substrat (SB1) erstreckt, wobei der Substratbereich (RSB) des ersten Transistors mindestens teilweise auf einem Ende (51) des ersten Polysiliziumbereichs aufliegt, der von der dielektrischen Schicht umgeben ist, und der Source- und der Drain-Bereich auf dem Isoliergraben aufliegen.

10. System nach Anspruch 9, wobei die integrierte Schaltung (IC) mindestens eine nichtflüchtige Speicherzelle vom Auswahltransistortyp mit einem in das erste Substrat vergrabenen Gate umfasst, und der erste Polysiliziumbereich eine Form aufweist, die der des vergrabenen Gates des Auswahltransistors entspricht.

11. System nach einem der Ansprüche 1 bis 4, wobei die integrierte Schaltung Folgendes umfasst:
- eine dielektrische Schicht (6), die zwischen dem ersten Polysiliziumbereich und dem ersten Substrat angeordnet ist, und
- einen zweiten MOS-Transistor (TR2), der im ersten Substrat einen Source-Bereich, einen Drain-Bereich und einen Substratbereich zwischen dem Source- und dem Drain-Bereich umfasst und von der dielektrischen Schicht bedeckt ist, wobei der erste Polysiliziumbereich einen Gate-Bereich aufweist, der dem ersten Transistor (TR1) und dem zweiten Transistor (TR2) gemeinsam ist.

12. System nach Anspruch 11, wobei der zweite Transistor (TR2) ein NMOS-Transistor oder ein PMOS-Transistor ist.

13. System nach einem der vorhergehenden Ansprüche, wobei der erste Kondensator (C1) und der zweite Kondensator (C2) Kondensatoren sind, die zwei Elektroden aus Polysilizium umfassen, die durch ein Dielektrikum getrennt sind und auf einem isolierenden Bereich der integrierten Schaltung aufliegen.

14. System nach einem der vorhergehenden Ansprüche, ferner umfassend einen passiven kontaktlosen Transponder (TG), der so konfiguriert ist, dass er mit einem Lesegerät (RD) über eine Antenne (ANT) unter Verwendung eines Trägersignals kommuniziert, wobei der Transponder (TG) die integrierte Schaltung (IC) aufweist, die zwei mit der Antenne verbundene Antennenanschlüsse (AC0, AC1) aufweist, wobei die integrierte Schaltung ein Vergleichsmittel, das so konfiguriert ist, dass es die Spannung der ersten Elektrode mit dem Schwellenwert vergleicht, und Verarbeitungsmittel (MT) umfasst, die für Folgendes konfiguriert sind:
- als Antwort auf einen ersten Befehl seitens des Lesegeräts, Steuern einer Ladung des ersten Kondensators,
- als Antwort auf einen zweiten Befehl seitens des Lesegeräts, Steuern einer Ladung des zweiten Kondensators,
- als Antwort auf einen Aktivierungsbefehl seitens des Lesegeräts, Aktivieren des Messmittels, und
- als Antwort auf einen Lesebefehl seitens des Lesegeräts, Übermitteln des Ergebnisses des Vergleichs.

15. Verfahren zum Detektieren einer vorhandenen oder nicht vorhandenen Abtrennung des abtrennbaren Teils des elektrisch leitenden Drahts des Systems nach einem der vorhergehenden Ansprüche, umfassend eine Ladung des ersten Kondensators (C1), eine Ladung des zweiten Kondensators (C2) und mindestens eine Messung der Spannung (VC2) der ersten Elektrode des zweiten Kondensators, und eine Analyse des Ergebnisses eines Vergleichs zwischen der gemessenen Spannung und dem Schwellenwert.

16. Verfahren nach Anspruch 15, umfassend, nachdem die beiden Kondensatoren ein einziges Mal aufgeladen wurden, mehrere Messungen der Spannung der ersten Elektrode, die zu zeitlich beabstandeten Messzeitpunkten (Ti) durchgeführt wurden, und mehrere Vergleiche zwischen den gemessenen Spannungen und dem Schwellenwert, wobei eine gemessene Spannung, die unterhalb des Schwellenwerts zu einem Messzeitpunkt liegt, einen abtrennbaren Teil anzeigt, der zu dem Messzeitpunkt oder zuvor zu diesem Messzeitpunkt durchtrennt wurde.

## Claims

1. A system, comprising an integrated circuit including
- a first substrate (SB1) and
- at least one first MOS transistor (TRP) having a first polysilicon region (P1) electrically insulated from the first substrate and including a gate region (RG), a second polysilicon region (P2) electrically insulated from the first polysilicon region (P1) and from the first substrate (SB1) and including a source region (RS), a substrate region (RSB) and a drain region (RD) of said first transistor, the first polysilicon region (P1) being located between a zone (Z) of the first substrate (SB1) and the second polysilicon region (P2), wherein the first transistor (TRP) is a PMOS transistor,
- the first PMOS transistor (TRP) has its source region connected to the ground and has a threshold voltage such that it is ON when a zero voltage is applied to its gate, and OFF in the presence of a negative bias of its gate, and wherein the system comprises:
- a closed container (RCP),
- the integrated circuit (IC) having a first and a second terminal (TDI, TDO) connected by an electrically conductive wire (FL1) having a severable part (FL10) and arranged to be severed at its severable part in case of opening or attempting to open the container, and
- a detection device (DSD) configured to detect severing of the severable part, the detection device including, within the integrated circuit, a first capacitor electrically insulated from the first substrate of the integrated circuit and connected to the first terminal, the first PMOS transistor having its gate connected to the second terminal and its source connected to the ground, a second capacitor electrically insulated from the first substrate of the integrated circuit and having a first electrode connected to the drain of the first PMOS transistor, and a measurement means configured to measure the voltage (VC2) of said first electrode,
- a voltage of said first electrode lower than a threshold being representative of present or past severing of said severable part.

2. The system according to claim 1, wherein the substrate region (RSB) of the first transistor is less doped than the first polysilicon region (P1).

3. The system according to claim 1 or 2, wherein the substrate region (RSB) of the first transistor comprises intrinsic polysilicon or has a dopant concentration of less than 10¹⁷ atoms/cm³.

4. The system according to one of the preceding claims, wherein the first polysilicon region (P1) has a dopant concentration greater than 10¹⁹ atoms/cm³.

5. The system according to any of the preceding claims, wherein the integrated circuit comprises an insulating trench (1) located in the first substrate, and the first polysilicon region (P1) is located above this insulating trench.

6. The system according to claim 5, wherein, in the source-drain direction of the first transistor, the first polysilicon region (P1) protrudes from the second polysilicon region (P2) and the second polysilicon region rests on the first polysilicon region via a first dielectric region.

7. The system according to claim 5, wherein
- the first polysilicon region (P1) protrudes from the second polysilicon region in a direction perpendicular to the source-drain direction of the first transistor, and
- in the source-drain direction of the first transistor, the dimension of the second polysilicon region (P2) is greater than the dimension of the first polysilicon region (P1), and the second polysilicon region rests on the first polysilicon region and on the insulating trench via a second dielectric region.

8. The system according to claim 5, wherein
- the first polysilicon region (P1) protrudes from the second polysilicon region in a direction perpendicular to the source-drain direction of the first transistor, and
- in the source-drain direction of the first transistor, the dimension of the second polysilicon region (P2) is greater than the dimension of the first polysilicon region, and the second polysilicon region rests on the first polysilicon region via a third dielectric region and also rests on the insulating trench.

9. The system according to any of claims 1 to 4, wherein the integrated circuit comprises an insulating trench (1) located in the first substrate and a dielectric layer (5) surrounding the first polysilicon region (P1), the first polysilicon region surrounded by its dielectric layer extending through the insulating trench (1) into the first substrate (SB1), the substrate region (RSB) of the first transistor at least partly resting on an end (51) of the first polysilicon region surrounded by said dielectric layer and the source and drain regions resting on the insulating trench.

10. The system according to claim 9, wherein the integrated circuit (IC) comprises at least one non-volatile memory cell of the selection transistor type having a gate buried in the first substrate, and the first polysilicon region has a shape analogous to that of the buried gate of said selection transistor.

11. The system according to one of claims 1 to 4, wherein the integrated circuit comprises
- a dielectric layer (6) disposed between the first polysilicon region and the first substrate, and
- a second MOS transistor (TR2) including, in the first substrate, a source region, a drain region and a substrate region between the source and drain regions and covered with said dielectric layer, the first polysilicon region including a gate region common to the first transistor (TR1) and the second transistor (TR2).

12. The system according to claim 11, wherein the second transistor (TR2) is an NMOS transistor or a PMOS transistor.

13. System according to one of the preceding claims, wherein the first capacitor (C1) and the second capacitor (C2) are capacitors including two polysilicon electrodes separated by a dielectric and resting on an insulating region of the integrated circuit.

14. The system according to one of the preceding claims, further comprising a contactless passive transponder (TG) configured to communicate with a reader (RD) via an antenna (ANT) using a carrier signal, the transponder (TG) including the integrated circuit (IC) having two antenna terminals (AC0, AC1) connected to the antenna, the integrated circuit including a comparison means configured to compare the voltage of said first electrode to said threshold, and processing means (MT) configured to
- in response to a first command coming from the reader, control charging of the first capacitor,
- in response to a second command coming from the reader, control charging of the second capacitor,
- in response to an activation command coming from the reader, activate the measurement means, and
- in response to a read command coming from the reader, communicate the result of said comparison.

15. A method for detecting present or past severing, or no severing, of the severable part of the electrically conductive wire of the system according to one of the preceding claims, comprising charging the first capacitor (C1), charging the second capacitor (C2) and at least one measurement of the voltage (VC2) of the first electrode of the second capacitor, and analysing the result of a comparison between said voltage measured and said threshold.

16. The method according to claim 15, comprising, having the two capacitors been charged only once, several measurements of the voltage of the first electrode carried out at time-spaced measurement instants (Ti) and several comparisons between these voltages measured and said threshold, a voltage measured lower than said threshold at a measurement instant indicating a severable part being severed at said measurement instant or prior to this measurement instant.
